(19) Europäisches Patentamt
European Patent Office
Office européen des brevets

(11) **EP 3 454 139 B1**

(12) **FASCICULE DE BREVET EUROPEEN**

(45) Date de publication et mention de la délivrance du brevet:
**17.06.2020 Bulletin 2020/25**

(51) Int Cl.:
*G04F 5/14* (2006.01)     *H01S 3/137* (2006.01)
*H01S 5/0687* (2006.01)   *H03L 7/26* (2006.01)

(21) Numéro de dépôt: **18192357.4**

(22) Date de dépôt: **04.09.2018**

(54) **SYSTÈME DE MESURE OPTIQUE À ASSERVISSEMENT DAVLL STABILISÉ ET PROCÉDÉ ASSOCIÉ**

OPTISCHES MESSSYSTEM MIT STABILISIERTER DAVLL-STEUERUNG UND VERFAHREN DAZU

OPTICAL MEASUREMENT SYSTEM WITH STABILISED DAVLL SERVO AND ASSOCIATED METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.09.2017 FR 1758217**

(43) Date de publication de la demande:
**13.03.2019 Bulletin 2019/11**

(73) Titulaire: **Commissariat à l'énergie atomique et aux énergies alternatives 75015 Paris (FR)**

(72) Inventeurs:
• **BEATO, François**
  **38600 FONTAINE (FR)**
• **PALACIOS LALOY, Agustin**
  **38000 GRENOBLE (FR)**

(74) Mandataire: **Brevalex**
**95, rue d'Amsterdam**
**75378 Paris Cedex 8 (FR)**

(56) Documents cités:
**US-A- 6 009 111**

• CORWIN K L ET AL: "FREQUENCY-STABILIZED DIODE LASER WITH THE ZEEMAN SHIFT IN AN ATOMICVAPOR", APPLIED OPTICS, OPTICAL SOCIETY OF AMERICA, WASHINGTON, DC; US, vol. 37, no. 15, 20 mai 1998 (1998-05-20), pages 3295-3298, XP000765284, ISSN: 0003-6935, DOI: 10.1364/AO.37.003295

• S. Pustelny ET AL: "Dichroic atomic vapor laser lock with multi-gigahertz stabilization range", arxiv.org, 6 juillet 2016 (2016-07-06), page 063107, XP055469375, DOI: 10.1063/1.4952962 Extrait de l'Internet: URL:https://arxiv.org/pdf/1512.08919.pdf [extrait le 2018-04-23]

• REEVES J M ET AL: "TEMPERATURE STABILITY OF A DICHROIC ATOMIC VAPOR LASER LOCK", APPLIED OPTICS, OPTICAL SOCIETY OF AMERICA, WASHINGTON, DC; US, vol. 45, no. 2, 10 janvier 2006 (2006-01-10), pages 372-376, XP001237450, ISSN: 0003-6935, DOI: 10.1364/AO.45.000372

• Vishal Shah ET AL: "A Miniature Cold-Atom Frequency Standard", , 24 novembre 2011 (2011-11-24), XP055469184, Extrait de l'Internet: URL:https://arxiv.org/ftp/arxiv/papers/111 1/1111.5890.pdf [extrait le 2018-04-20]

• SHAH V ET AL: "A Miniature Cold Atom Frequency Standard", PTTI 2011 - PROCEEDINGS OF THE 43RD ANNUAL PRECISE TIME AND TIME INTERVAL SYSTEMS AND APPLICATIONS MEETING, THE INSTITUTE OF NAVIGATION, 8551 RIXLEW LANESUITE 360MANASSAS, VA 20109, USA, 17 novembre 2011 (2011-11-17), pages 221-230, XP056011360,

## Description

## DOMAINE TECHNIQUE

Le domaine de l'invention est celui de l'asservissement de la longueur d'onde de la lumière émise par un laser sur une transition atomique. L'invention concerne plus particulièrement un asservissement dit DAVLL (pour Dichroïc Atomic Vapor Laser Lock) qui réalise une séparation par décalage Zeeman de composantes de polarisation d'un faisceau laser et génère un signal d'erreur qui correspond à la différence des taux d'absorption de ces composantes de polarisation dans une vapeur atomique.

## ÉTAT DE LA TECHNIQUE ANTÉRIEURE

Les capteurs atomiques utilisent un ensemble d'atomes en faible interaction les uns avec les autres comme élément sensible pour mesurer et/ou suivre différentes grandeurs physiques (temps, champ magnétique, accélération par exemple) avec une haute sensibilité et/ou une haute exactitude.

Ces capteurs se divisent en deux grandes familles. On compte ainsi d'une part les capteurs exploitant un gaz atomique chauffé ou thermalisé avec l'environnement (ce qui implique des vitesses de diffusion importantes, typiquement de l'ordre de 10 à 1000 m/s), souvent appelés capteurs à atomes chauds ou capteurs à pompage optique. Et on dénombre d'autre part les capteurs qui mettent en œuvre des techniques de piégeage et de refroidissement laser pour s'affranchir des effets thermiques et de déplacement des atomes. Les atomes sont ainsi confinés dans un volume de mesure où l'état de chaque atome peut être contrôlé et mesuré de façon individuelle. Ces capteurs sont dits à atomes froids.

On notera également que certains systèmes, tels que les centres azote-lacune du diamant, qui même s'ils sont en état solide ont un spectre d'énergie proche des atomes d'un gaz atomique et présentent des comportements semblables. Ces systèmes sont ainsi souvent inclus dans le domaine des capteurs atomiques.

L'exactitude de ces capteurs atomiques repose sur l'invariabilité des propriétés des atomes : tous les atomes d'une espèce chimique sont effectivement parfaitement équivalents entre eux, et ont des propriétés calculables et invariantes dans le temps. Ceci permet notamment de s'affranchir des dérives qui apparaissent sur d'autres capteurs, tels que des capteurs mécaniques ou électriques réalisés en semi-conducteurs qui sont sujets à un vieillissement qui fait inévitablement varier leur comportement au cours du temps.

Ainsi, on trouve parmi les capteurs atomiques des horloges atteignant d'excellents niveaux d'exactitude (horloges atomiques), mais également des magnétomètres, gyroscopes, accéléromètres et gravimètres atomiques qui permettent des mesures très précises respectivement du champ magnétique, de la rotation, de l'accélération et du champ gravitationnel. Dans d'autres capteurs visant la sensibilité plutôt que l'exactitude, le bénéfice obtenu provient de la faible interaction entre les différents atomes : c'est notamment le cas pour les magnétomètres bas-bruit basés sur des atomes non refroidis.

La plupart de ces capteurs mettent en œuvre des sources de lumière de type laser. Ces sources de lumière se caractérisent notamment par une grande finesse spectrale, la lumière n'étant émise que dans une gamme très étroite de longueur d'onde autour d'une valeur centrale (l'écart type étant de l'ordre de quelques dizaines de MHz, mais pouvant atteindre le Hz sur certains lasers). Cette finesse spectrale est importante pour permettre de s'accorder de façon contrôlée aux différentes transitions atomiques nécessaires à préparer les atomes pour la mesure ou à obtenir de l'information sur l'état des atomes. Dans ce même but, il est important que la lumière soit accordée de façon très précise à la longueur d'onde souhaitée sans qu'il existe un décalage systématique ou une dérive entre la position de la raie laser et la ou les transitions atomiques utilisées.

On cherche donc d'une manière générale à asservir les paramètres de contrôle du laser de manière à ce qu'ils soient stables à une longueur d'onde fixe par rapport à une transition atomique donnée. L'objectif est que l'écart entre la longueur d'onde centrale de la lumière émise par le laser et celle de la transition atomique visée soit inférieure à des valeurs qui pourraient induire des effets indésirables, tels que des pertes de signal, l'absence de refroidissement laser, des décalages lumineux (effet connu comme « light-shift » ou « AC-Stark shift » consistant en ce qu'une lumière polarisée circulairement et non accordée à une transition atomique se comporte comme un champ magnétique fictif perturbant le comportement des atomes) ou d'autres effets apparentés introduisant des défauts significatifs dans le fonctionnement d'un capteur atomique.

Différentes techniques d'asservissement d'un laser à une transition atomique ont pu être proposées. On connait notamment une technique consistant à réaliser une modulation de la longueur d'onde du laser autour de la transition atomique visée et à réaliser l'asservissement de sa symétrie impaire à zéro (technique connue dans la littérature comme « dither lock »). Cette technique présente toutefois l'inconvénient d'être peu sensible aux écarts de longueur d'onde et de demander une modulation du laser. Or cette modulation est pénalisante. En effet, même si la longueur d'onde centrale du laser est bien fixée sur la transition atomique, la modulation induit un étalement spectral sur une gamme de l'ordre de la gamme d'accrochage de l'asservissement. Cette gamme d'accrochage est par ailleurs au maximum de l'ordre de la largeur de la raie atomique utilisée comme référence, et ne peut pas être très inférieure à celle-ci.

Une amélioration permettant d'augmenter la sensibilité de l'asservissement est basée sur des techniques d'absorption saturée (connues également comme « Doppler-free spectroscopy ») qui permettent d'accéder à la raie atomique en s'affranchissant des élargissements provenant de la vitesse thermique des atomes.

On connait par ailleurs, par exemple des documents [1] et [2] cités à la fin de la description, une technique d'asservissement qui évite toute modulation du laser. Ce principe d'asservissement repose sur le dichroïsme d'une vapeur atomique soumise à un champ magnétique important (de l'ordre de 1-1000 mT). Cette technique est connue dans la littérature comme DAVLL (« Dichroïc Atomic Vapor Laser Lock »).

Cette technique DAVLL exploite un aimant pour séparer les raies correspondantes aux polarisations circulaires σ+ et σ- d'un décalage supérieur à la largeur de la raie optique de la transition atomique visée (cette largeur étant fixée soit par l'élargissement Doppler soit par son élargissement en pression). Le gaz atomique acquiert ainsi un dichroïsme circulaire qui s'annule très précisément pour la longueur d'onde correspondant à la transition atomique. Ce dichroïsme est mesuré par un montage optique de polarimétrie consistant en une lame quart d'onde qui vient convertir les polarisations circulaires σ+ et σ- en polarisations linéaires, un séparateur de faisceau qui vient séparer les polarisations linéaires et deux photodiodes qui reçoivent chacune l'une des polarisations linéaires. Les courants de ces photodiodes sont proportionnels aux intensités des polarisations circulaires gauche et droite en sortie de la cellule de gaz atomique. Ces courants sont transformés en tensions par des amplificateurs transimpédance. La différence de ces tensions forme un signal DAVLL. L'asservissement du signal DAVLL sur un zéro permet un calage du laser sur le centre de la transition atomique, notamment en venant fournir une consigne de tension à un transducteur piézoélectrique qui pilote l'orientation d'un miroir de sortie du laser pour un laser à cavité, ou en venant fournir une consigne de courant à un module Peltier qui contrôle la température de la diode pour le cas d'un laser semi-conducteur.

Il a été observé que la stabilité thermique des montages optiques de polarimétrie nécessaires pour générer un signal DAVLL est critique pour la stabilité de l'asservissement. Le document [3] cité à la fin de la description illustre à cet égard les difficultés qui peuvent apparaître lorsque le montage de polarimétrie est sensible à la température.

L'utilisation d'éléments optiques de grande stabilité thermique permet en partie de résoudre le problème, mais rend le montage de polarimétrie onéreux et exclut l'utilisation d'éléments basés sur des films polymères polarisants. Le document [3] propose des réglages du montage optique dépendants du point d'asservissement, ce qui permet de n'être sensible qu'au deuxième ordre à des variations de température. Mais cette dernière solution requiert des réglages complexes et ne résout pas entièrement le problème.

## EXPOSÉ DE L'INVENTION

L'invention a pour objectif d'améliorer la stabilité, notamment thermique, d'un asservissement DAVLL au moyen d'une technique simple à mettre en œuvre et peu coûteuse.

A cet effet, elle propose un procédé selon la revendication 1.

Certains aspects préférés mais non limitatifs de ce procédé sont définis dans les revendications dépendantes 2 à 13.

L'invention porte également sur un système de mesure optique conforme à la revendication 14.

## BRÈVE DESCRIPTION DES DESSINS

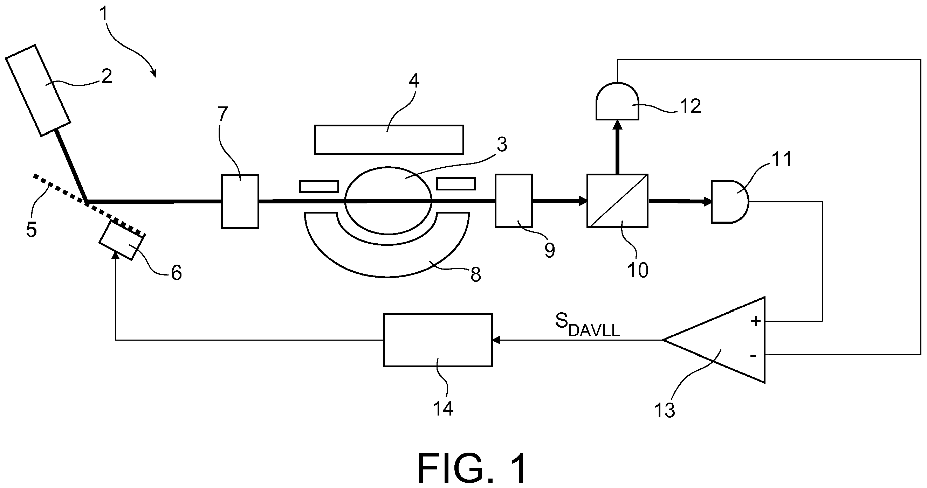

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence à la figure 1 annexée qui représente un schéma d'un système de mesure optique selon un mode de réalisation possible de l'invention.

## EXPOSÉ DÉTAILLÉ DE MODES DE RÉALISATION PARTICULIERS

L'invention porte sur un procédé et un système d'asservissement DAVLL de la longueur d'onde (centrale) d'un laser sur une transition atomique. En référence à la figure 1, le laser 2 équipe un système de mesure optique qui comprend une cellule 3 remplie d'une vapeur atomique, ladite cellule 3 étant agencée pour recevoir un faisceau laser émis par le laser, et une source d'énergie 4 pour réaliser un apport d'énergie aux atomes de la vapeur atomique.

Le laser 2 peut comprendre un miroir de sortie 5 monté sur un transducteur piézoélectrique 6 apte à en piloter la position et/ou l'orientation en fonction d'une consigne de tension fournie audit transducteur 6. Le laser 2 peut alternativement comprendre un module Peltier apte à contrôler la température d'une diode en fonction d'une consigne de courant.

La source d'énergie 4 est chargée d'amener les atomes de la vapeur atomique dans un état énergisé où ils sont aptes à subir ladite transition atomique lorsqu'ils sont éclairés par le faisceau laser. En d'autres termes, dans l'état énergisé, les atomes de la vapeur atomique affectent les propriétés de lumière laser traversant la cellule 3 de manière suffisamment intense pour que les modifications de ces propriétés soient mesurables.

La source d'énergie 4 peut être une source de décharge HF (dans le cas de l'hélium par exemple) ou une source d'énergie thermique (dans le cas de métaux alcalins par exemple, pour assurer une densité suffisante en phase gazeuse). Prenant l'exemple d'une cellule remplie d'hélium, la transition atomique visée correspond par exemple à la raie $D_0$ (soit une longueur d'onde centrale à 1083,205 nm) et la source d'énergie 4 est chargée d'amener les atomes d'hélium dans l'état métastable $2^3S_1$. La source d'énergie est typiquement une source de décharge HF qui amène les atomes d'hélium dans l'état métastable par création d'un plasma et cascade radiative.

Le système d'asservissement du laser 1 comprend un montage optique de polarimétrie 7-13 configuré pour générer un signal DAVLL $S_{DAVLL}$ à partir du faisceau laser ayant traversé la cellule et un circuit d'asservissement 14 de la longueur d'onde du laser à l'aide du signal DAVLL $S_{DAVLL}$.

De manière connue en soit, le montage optique de polarimétrie comprend en amont de la cellule 3 un polariseur 7 qui reçoit le faisceau laser et crée une polarisation qui est une combinaison de deux polarisations d'un premier type sensibles au dichroïsme des atomes. Le polariseur 7 est ainsi un polariseur linéaire venant créer une combinaison de deux polarisations circulaires lorsque les atomes présentent un dichroïsme circulaire (c'est le cas de l'hélium notamment). Le polariseur 7 est un polariseur circulaire venant créer une combinaison de deux polarisations linéaires lorsque les atomes présentent un dichroïsme linéaire.

Le montage optique de polarimétrie comprend par ailleurs une source de dichroïsme 8 entourant la cellule 3 pour séparer les deux polarisations du premier type. La source de dichroïsme 8 est par exemple une source de champ magnétique. La source de champ magnétique peut comprendre un ou plusieurs aimants agencés autour de la cellule.

Dans une première alternative, la source de champ magnétique peut comprendre une bobine agencée autour de la cellule, ladite bobine étant parcourue par un courant constant.

Dans une deuxième alternative, la source de champ magnétique est une source de champ magnétique fictif induit par des décalages lumineux du faisceau laser non accordés à la transition atomique visée (effet connu sous le nom de « light-shift » ou de décalage Stark alternatif pour « AC-Stark shift »). A cet effet, un autre faisceau laser peut être utilisé qui se propage perpendiculairement au faisceau laser utilisé pour obtenir le signal DAVLL. Cet autre faisceau laser est volontairement décalé en fréquence par rapport à la transition d'intérêt ($D_0$ par exemple) ce qui induit dans le système un champ magnétique fictif, et induit les mêmes propriétés de dichroïsme que précédemment.

Le montage optique de polarimétrie comporte en outre, en aval de la cellule 3, un convertisseur de polarisation 9, typiquement une lame quart d'onde, pour convertir les deux polarisations du premier type en sortie de la cellule en deux polarisations d'un second type, et un séparateur de faisceaux 10 pour séparer les deux polarisations du second type en deux faisceaux. Prenant l'exemple d'un polariseur 7 du type linéaire, le convertisseur de polarisation 9 convertit les deux polarisations circulaires en deux polarisations linéaires, et le séparateur 10 vient séparer les deux polarisations linéaires en deux faisceaux. Chacun de ces faisceaux est dirigé vers un photodétecteur 11, 12. Chaque photodétecteur 11, 12 convertit le faisceau photodétecté en une tension correspondante. Les tensions délivrées par les photodétecteurs 11, 12 sont soustraites l'une à l'autre par un calculateur 13, fournissant ainsi le signal DAVLL qui sert de signal d'erreur pour l'asservissement en longueur d'onde du laser. Dans un mode de réalisation possible, le calculateur réalise le calcul d'un déséquilibre normalisé en calculant le ratio de la différence des tensions délivrées par les photodétecteurs 11, 12 par la somme desdites tensions.

Ainsi, l'étape consistant à générer un signal DAVLL à partir du faisceau laser ayant traversé la cellule comprend les opérations consistant à :

- polariser, à l'aide du polariseur 7, le faisceau laser pour créer une combinaison de deux polarisations d'un premier type ;
- séparer les deux polarisations du premier type au moyen de la source de dichroïsme 8 ;
- convertir, au moyen du convertisseur 9, les deux polarisations du premier type en sortie de la cellule en deux polarisations d'un second type ;
- séparer, au moyen du séparateur 10, les deux polarisations du second type en deux faisceaux ;
- photodétecter les deux faisceaux séparés et convertir les faisceaux photodétectés en tensions correspondantes, au moyen des photodétecteurs 11, 12 ; et
- mesurer la différence desdites tensions au moyen du calculateur 13.

Le séparateur 10 peut être un cube séparateur formé par deux prismes droits non biréfringents et un film polymère polarisant disposé entre les deux faces collées des prismes. Ainsi la séparation de polarisations est assurée par le film polymère qui réfléchit une des polarisations et transmet l'autre. Des tels prismes sont nettement moins coûteux que des prismes réalisés en matières biréfringentes.

La lame quart d'onde peut être choisie en polymère ou en quartz, la version quartz présentant une meilleure stabilité thermique.

Dans le cadre de l'invention, la source d'énergie 4 en charge d'énergiser les atomes de la cellule 3 est configurée pour réaliser l'alternance d'une première phase et d'une deuxième phase. Plus particulièrement, la première phase apporte plus d'énergie que la deuxième phase.

L'apport d'énergie de la première phase présente une intensité telle que les atomes sont amenés dans l'état énergisé (l'état métastable $2^3S_1$ dans le cas de l'hélium) où ils sont aptes à subir ladite transition atomique lorsqu'ils sont éclairés par le faisceau laser.

Cette modulation de l'intensité de la source d'énergie 4 vient ainsi alterner une première phase où l'on dispose d'une forte densité d'atomes dans un état où ils sont susceptibles de subir ladite transition atomique, et une deuxième phase où l'on dispose d'une densité moindre, voire nulle, de ces atomes.

La forte densité d'atomes obtenue par la mise en œuvre de la première phase permet que la lumière laser traversant la cellule soit affectée par les atomes de manière suffisamment intense pour que les modifications soient mesurables.

En revanche, la faible, voire nulle, intensité de la deuxième phase permet de mesurer la réponse optique du capteur atomique. La connaissance de cette réponse optique permet alors de s'affranchir des variations optiques lentes par rapport à la vitesse de la modulation de la source d'énergie 4, comme par exemple des variations liées à des variations de température.

La fréquence de l'alternance entre la première et la deuxième phase d'apport d'énergie est de préférence d'au plus 1 kHz. On notera que l'asservissement en longueur d'onde des lasers semi-conducteurs est habituellement réalisé sur le module Peltier qui contrôle leur température (en effet l'autre paramètre de contrôle du laser, le courant, induit, outre des variations de longueur d'onde, des variations importantes de puissance optique qui ne sont pas désirables). Or la bande passante d'un tel module Peltier est typiquement inférieure au Hz de sorte que la modulation de l'apport d'énergie selon l'invention n'introduit aucune perte d'information.

L'apport d'énergie de la deuxième phase peut présenter une intensité nulle. Alternativement, l'apport d'énergie de la deuxième phase peut présenter une intensité non nulle. Cette alternative peut être avantageuse lorsque la modulation de l'apport d'énergie est réalisée à une fréquence telle que les atomes énergisés lors de la première phase n'ont pas le temps de retourner à leur état fondamental avant d'être à nouveau énergisés. Dans un tel cas de figure, on réalise alors une modulation qui modifie l'intensité de l'apport d'énergie, entre un apport intense lors la première phase et un apport moins intense lors de la deuxième phase.

Dans le cadre de l'invention, le calculateur 13 est configuré pour calculer un signal DAVLL correspondant à la différence des tensions délivrées par les photodétecteurs débarrassée des variations optiques lentes. Pour éliminer ces variations optiques lentes, pour chacun des photodétecteurs 11, 12, on soustrait la tension mesurée par le photodétecteur lors de la deuxième phase d'apport d'énergie à la tension mesurée par le photodétecteur lors de la deuxième phase d'apport d'énergie.

Le signal DAVLL peut ainsi s'écrire $(V_{1,Ph1} - V_{1,Ph2}) - (V_{2,Ph1} - V_{2,Ph2})$, où :

- $V_{1,Ph1}$ représente la tension mesurée par le premier photodétecteur 11 lors de la première phase de l'apport d'énergie ;
- $V_{1,Ph2}$ représente la tension mesurée par le premier photodétecteur 11 lors de la deuxième phase de l'apport d'énergie ;

- $V_{2,Ph1}$ représente la tension mesurée par un deuxième photodétecteur 12 lors de la première phase de l'apport d'énergie ; et
- $V_{2,Ph2}$ représente la tension mesurée par le deuxième photodétecteur 12 lors de la deuxième phase de l'apport d'énergie.

Ce signal peut également être normalisé selon :
$\frac{V_{1,Ph1} - V_{1,Ph2}}{V_{1,Ph2}} - \frac{V_{2,Ph1} - V_{2,Ph2}}{V_{2,Ph2}}$. Et dans un mode de réalisation possible, le calculateur 13 vient déterminer pour signal DAVLL le déséquilibre normalisé suivant :

$$\frac{\dfrac{V_{1,Ph1} - V_{1,Ph2}}{V_{1,Ph2}} - \dfrac{V_{2,Ph1} - V_{2,Ph2}}{V_{2,Ph2}}}{\dfrac{V_{1,Ph1} - V_{1,Ph2}}{V_{1,Ph2}} + \dfrac{V_{2,Ph1} - V_{2,Ph2}}{V_{2,Ph2}}}$$

Le calcul de ce déséquilibre normalisé présente l'avantage de permettre de s'affranchir des variations d'intensité de l'apport d'énergie sur plusieurs cycles de la modulation, ainsi que des variations d'intensité du laser.

Le signal DAVLL $S_{DAVLL}$ déterminé par le calculateur 13 est fourni à un circuit d'asservissement 14 de la longueur d'onde du laser qui, en fonction du signal d'erreur DAVLL, peut venir fournir une consigne de tension pour le transducteur piézoélectrique 6 pilotant le miroir de sortie 5 du laser ou une consigne de courant pour le module Peltier.

Lorsque la source de dichroïsme 8 prend la forme d'une source de champ magnétique contrôlable, comme c'est les cas des deux alternatives mentionnées précédemment (bobine parcourue par un courant et faisceau laser induisant un champ magnétique fictif), l'apport d'énergie aux atomes de la vapeur atomique peut être modulé pour comprendre une troisième phase d'apport d'énergie réalisée en séquence des première et deuxième phases discutées précédemment. Les première et deuxième phases s'opèrent avec un champ magnétique, généré par la source de dichroïsme, constant. Lors de la troisième phase, ce champ magnétique constant est interrompu tandis qu'un apport d'énergie aux atomes de la vapeur atomique est réalisé, par exemple tel que lors de la première phase, pour disposer d'une forte densité d'atomes dans un état où ils sont susceptibles de subir la transition atomique. Cette troisième phase permet de se ramener à une architecture de magnétomètre classique. De plus, lors de cette troisième phase, la source de champ magnétique pour être utilisé afin de créer un champ magnétique radiofréquence, permettant de réaliser une mesure de type magnétométrie. On combine alors en un seul système l'asservissement en longueur d'onde du laser et une mesure opérationnelle de magnétométrie.

## RÉFERENCES

[1] B. Chéron, H. Gilles, J. Hamel, O. Moreau, H. Sorel. Laser frequency stabilization using Zeeman effect. Journal de Physique III, EDP Sciences, 1994, 4 (2), pp.401-406.
[2] US 6,099,111
[3] J. M. Reeves, O. Garcia, C. A. Sackett. Temperature stability of a dichroic atomic vapor laser lock. Appl. Opt., AO, vol. 45, no. 2, pp. 372-376, 2006

## Revendications

1. Procédé d'asservissement de la longueur d'onde d'un laser (2) sur une transition atomique, comprenant les étapes consistant à :

   - émettre un faisceau laser en direction d'une cellule (3) remplie d'une vapeur atomique ;
   - réaliser un apport d'énergie aux atomes de la vapeur atomique à l'aide d'une source d'énergie (4) ;
   - générer un signal DAVLL ($S_{DAVLL}$) à partir du faisceau laser ayant traversé la cellule (3); et
   - asservir la longueur d'onde du laser à l'aide du signal DAVLL ;

   **caractérisé en ce qu'**une intensité de l'apport d'énergie est modulée pour réaliser l'alternance d'une première phase et d'une deuxième phase, l'intensité de l'apport d'énergie étant nulle ou non-nulle au cours de la deuxième phase et inférieure à l'intensité de l'apport d'énergie au cours de la première phase.

2. Procédé selon la revendication 1, dans lequel l'apport d'énergie de la première phase présente une intensité telle que les atomes sont amenés dans un état énergisé où ils sont aptes à subir ladite transition atomique lorsqu'ils sont éclairés par le faisceau laser.

3. Procédé selon l'une des revendications 1 à 2, dans lequel l'étape consistant à générer un signal DAVLL à partir du faisceau laser ayant traversé la cellule comprend les opérations consistant à :

   - polariser le faisceau laser pour créer une combinaison de deux polarisations d'un premier type ;
   - séparer les deux polarisations du premier type au moyen d'une source de dichroïsme (8) ;
   - convertir les deux polarisations du premier type en sortie de la cellule en deux polarisations d'un second type ;
   - séparer les deux polarisations du second type en deux faisceaux ;
   - photodétecter les deux faisceaux séparés, convertir les faisceaux photodétectés en tensions correspondantes et mesurer la différence desdites tensions.

4. Procédé selon la revendication 3, dans lequel la mesure de la différence desdites tensions comprend le calcul du déséquilibre normalisé suivant :

$$\frac{\dfrac{V_{1,Ph1} - V_{1,Ph2}}{V_{1,Ph2}} - \dfrac{V_{2,Ph1} - V_{2,Ph2}}{V_{2,Ph2}}}{\dfrac{V_{1,Ph1} - V_{1,Ph2}}{V_{1,Ph2}} + \dfrac{V_{2,Ph1} - V_{2,Ph2}}{V_{2,Ph2}}}$$

où :

   $V_{1,Ph1}$ représente la tension mesurée par un premier photodétecteur (11) lors de la première phase de l'apport d'énergie ;
   $V_{1,Ph2}$ représente la tension mesurée par le premier photodétecteur (11) lors de la deuxième phase de l'apport d'énergie ;
   $V_{2,Ph1}$ représente la tension mesurée par un deuxième photodétecteur (12) lors de la première phase de l'apport d'énergie ; et
   $V_{2,Ph2}$ représente la tension mesurée par le deuxième photodétecteur (12) lors de la deuxième phase de l'apport d'énergie.

5. Procédé selon l'une des revendications 3 et 4, dans lequel la source de dichroïsme (8) est une source de champ magnétique.

6. Procédé selon la revendication 5, dans lequel la source de champ magnétique comprend un ou plusieurs aimants agencés autour de la cellule.

7. Procédé selon la revendication 5, dans lequel la source de champ magnétique comprend une bobine agencée autour de la cellule, ladite bobine étant parcourue par un courant constant.

8. Procédé selon la revendication 5, dans lequel la source de champ magnétique est un champ magnétique fictif induit par un décalage Stark alternatif.

9. Procédé selon l'une des revendications 7 et 8, dans lequel l'apport d'énergie aux atomes de la vapeur atomique est modulé pour comprendre une troisième phase d'apport d'énergie en séquence des première et deuxième phases, l'intensité de l'apport d'énergie de la troisième phase étant identique à l'intensité de l'apport d'énergie de la première phase et la source de champ magnétique étant interrompue lors de la troisième phase.

**10.** Procédé selon l'une des revendications 1 à 9, dans lequel la cellule (3) renferme de l'hélium, la transition atomique correspond à la raie $D_0$ et l'apport d'énergie de la première phase présente une intensité telle que les atomes d'hélium sont amenés dans l'état métastable $2^3S_1$.

**11.** Procédé selon l'une des revendications 1 à 10, dans lequel la source d'énergie (4) est une source de décharge HF.

**12.** Procédé selon l'une des revendications 1 à 10, dans lequel la source d'énergie (4) est une source d'énergie thermique.

**13.** Procédé selon l'une des revendications 1 à 12, dans lequel la fréquence de l'alternance entre la première et la deuxième phase d'apport d'énergie est d'au plus 1 kHz.

**14.** Système de mesure optique, comprenant :

- une cellule (3) remplie d'une vapeur atomique et agencée pour recevoir un faisceau laser émis par un laser ;
- une source d'énergie (4) pour réaliser un apport d'énergie aux atomes de la vapeur atomique;
- un montage optique de polarimétrie (7-13) configuré pour générer un signal DAVLL ($S_{DAVLL}$) à partir du faisceau laser ayant traversé la cellule ; et
- un circuit d'asservissement (14) de la longueur d'onde du laser sur une transition atomique à l'aide du signal DAVLL;

**caractérisé en ce que** la source d'énergie (4) est configurée pour moduler une intensité de l'apport d'énergie en réalisant l'alternance d'une première phase et d'une deuxième phase, l'intensité de l'apport d'énergie étant nulle ou non-nulle au cours de la deuxième phase et inférieure à l'intensité de l'apport d'énergie au cours de la première phase.

**Patentansprüche**

**1.** Verfahren zum Steuern der Wellenlänge eines Lasers (2) bei einem atomaren Übergang, umfassend die folgenden Schritte:

- Emittieren eines Laserstrahls in Richtung einer mit einem atomaren Dampf gefüllten Zelle (3),
- Erbringen eines Energieeintrags in die Atome des atomaren Dampfes mit Hilfe einer Energiequelle (4);

- Erzeugen eines DAVLL-Signals ($S_{DAVLL}$) aus dem Laserstrahl, der die Zelle (3) durchquert hat; und
- Steuern der Wellenlänge des Lasers mit Hilfe des DAVLL-Signals;

**dadurch gekennzeichnet, dass**
eine Intensität des Energieeintrags moduliert wird, um einen Wechsel einer ersten Phase und einer zweiten Phase zu erhalten, wobei die Intensität des Energieeintrags während der zweiten Phase null oder ungleich null ist und niedriger als die Intensität des Energieeintrags während der ersten Phase ist.

**2.** Verfahren nach Anspruch 1,
wobei
der Energieeintrag der ersten Phase eine solche Intensität hat, dass die Atome in einen erregten Zustand gebracht werden, in dem sie in der Lage sind, diesen atomaren Übergang zu durchlaufen, wenn sie mit dem Laserstrahl bestrahlt werden.

**3.** Verfahren nach einem der Ansprüche 1 bis 2,
wobei
der Schritt der Erzeugung eines DAVLL-Signals aus dem Laserstrahl, der die Zelle durchquert hat, folgende Vorgänge umfasst:

- Polarisieren des Laserstrahls, um eine Kombination von zwei Polarisationen eines ersten Typs zu erzeugen;
- Trennen der beiden Polarisationen des ersten Typs mittels einer dichroitischen Quelle (8);
- Umwandeln der beiden Polarisationen des ersten Typs am Ausgang der Zelle in zwei Polarisationen eines zweiten Typs;
- Trennen der beiden Polarisationen des zweiten Typs in zwei Strahlen;
- Photodetektion der beiden getrennten Strahlen, Umwandeln der photodetektierten Strahlen in entsprechende Spannungen und Messen der Differenz dieser Spannungen.

**4.** Verfahren nach Anspruch 3,
wobei die Messung der Differenz der genannten Spannungen die Berechnung des folgenden normierten Ungleichgewichts umfasst:

$$\frac{\dfrac{V_{1,Ph1} - V_{1,Ph2}}{V_{1,Ph2}} - \dfrac{V_{2,Ph1} - V_{2,Ph2}}{V_{2,Ph2}}}{\dfrac{V_{1,Ph1} - V_{1,Ph2}}{V_{1,Ph2}} + \dfrac{V_{2,Ph1} - V_{2,Ph2}}{V_{2,Ph2}}}$$

worin

$V_{1, Ph1}$ die Spannung darstellt, die von einem ersten Photodetektor (11) während der ersten Phase des Energieeintrags gemessen wird;
$V_{1, Ph2}$ die Spannung darstellt, die von dem ersten Photodetektor (11) während der zweiten Phase des Energieeintrags gemessen wird;
$V_{2, Ph1}$ die Spannung darstellt, die von einem zweiten Photodetektor (12) während der ersten Phase des Energieeintrags gemessen wird; und
$V_{2, Ph2}$ die Spannung darstellt, die von dem zweiten Photodetektor (12) während der zweiten Phase des Energieeintrags gemessen wird.

5. Verfahren nach einem der Ansprüche 3 und 4,
wobei
die dichroitische Quelle (8) eine Magnetfeldquelle ist.

6. Verfahren nach Anspruch 5,
wobei
die Magnetfeldquelle einen oder mehrere Magnete aufweist, die um die Zelle herum angeordnet sind.

7. Verfahren nach Anspruch 5,
wobei
die Magnetfeldquelle eine Spule aufweist, die um die Zelle herum angeordnet ist, wobei die Spule von einem konstanten Strom durchflossen wird.

8. Verfahren nach Anspruch 5,
wobei
die Magnetfeldquelle ein fiktives Magnetfeld ist, das von einer AC-Stark-Verschiebung induziert wird.

9. Verfahren nach einem der Ansprüche 7 und 8,
wobei
der Energieeintrag in die Atome des atomaren Dampfes so moduliert wird, dass er eine dritte Phase des Energieeintrags sequenziell zur ersten und zweiten Phase umfasst, wobei die Intensität des Energieeintrags der dritten Phase die gleiche ist wie die Intensität des Energieeintrags der ersten Phase und wobei die Magnetfeldquelle in der dritten Phase unterbrochen wird.

10. Verfahren nach einem der Ansprüche 1 bis 9,
wobei
die Zelle (3) Helium enthält, wobei der atomare Übergang der Linie $D_0$ entspricht und der Energieeintrag der ersten Phase eine solche Intensität aufweist, dass die Heliumatome in den metastabilen Zustand $2^3S_1$ gebracht werden.

11. Verfahren nach einem der Ansprüche 1 bis 10,
wobei
die Energiequelle (4) eine HF-Entladungsquelle ist.

12. Verfahren nach einem der Ansprüche 1 bis 10,
wobei
die Energiequelle (4) eine thermische Energiequelle ist.

13. Verfahren nach einem der Ansprüche 1 bis 12,
wobei
die Frequenz des Wechsels zwischen der ersten und der zweiten Phase des Energieeintrags höchstens 1 kHz beträgt.

14. Optisches Messsystem, enthaltend:

- eine Quelle (3), die mit einem atomaren Dampf gefüllt und dazu vorgesehen ist, einen von einem Laser emittieren Laserstrahl aufzunehmen;
- eine Energiequelle (4) zum Erbringen eines Energieeintrags in die Atome des atomaren Dampfes;
- eine optische Polarimetrie-Anordnung (7 - 13), die dazu ausgelegt ist, ein DAVLL-Signal ($S_{DAVLL}$) aus dem Laserstrahl, der die Zelle durchquert hat, zu erzeugen; und
- eine Steuerschaltung (14) zum Steuern der Wellenlänge des Lasers bei einem atomaren Übergang mit Hilfe des DAVLL-Signals;

**dadurch gekennzeichnet, dass**
die Energiequelle (4) dazu ausgelegt ist, eine Intensität des Energieeintrags zu modulieren, indem ein Wechsel einer ersten Phase und einer zweiten Phase erfolgt, wobei die Intensität des Energieeintrags während der zweiten Phase null oder ungleich null ist und niedriger als die Intensität des Energieeintrags während der ersten Phase ist.

**Claims**

1. Method of controlling the wavelength of a laser (2) on an atomic transition, comprising the steps consisting in:

- emitting a laser beam towards a cell (3) filled with an atomic vapour;
- supplying energy to the atoms of the atomic vapour using a source of energy (4);
- generating a DAVLL signal ($S_{DAVLL}$) using the laser beam that has passed through the cell; and
- controlling the wavelength of the laser using the DAVLL signal;

**characterized in that** an intensity of the energy supplying is modulated to carry out the alternating of a first phase and of a second phase, the intensity of the energy supplying being null or non-null in the second phase and less than the intensity of the energy supplying in the first phase.

2. Method according to claim 1, wherein the energy supplying of the first phase has an intensity such that the atoms are brought in an energised state in which they are able to undergo said atomic transition when they are illuminated by the laser beam.

3. Method according to one of claims 1 to 2, wherein the step consisting in generating a DAVLL signal using the laser beam that has passed through the cell comprises the operations consisting in:

- polarising the laser beam in order to create a combination of two polarisations of a first type;
- separating the two polarisations of the first type by means of a source of dichroism (8);
- converting the two polarisations of the first type at an output of the cell into two polarisations of a second type;
- separating the two polarisations of the second type into two beams;
- photodetecting the two separated beams, converting the photodetected beams into corresponding voltages and measuring the difference of said voltages.

4. Method according to claim 3, wherein measuring of the difference of said voltages comprises calculating the following standardised imbalance:

$$\frac{\dfrac{V_{1,Ph1} - V_{1,Ph2}}{V_{1,Ph2}} - \dfrac{V_{2,Ph1} - V_{2,Ph2}}{V_{2,Ph2}}}{\dfrac{V_{1,Ph1} - V_{1,Ph2}}{V_{1,Ph2}} + \dfrac{V_{2,Ph1} - V_{2,Ph2}}{V_{2,Ph2}}}$$

wherein:

$V_{1,Ph1}$ represents the voltage measured by a first photodetector (11) during the first phase of the energy supplying;
$V_{1,Ph2}$ represents the voltage measured by the first photodetector (11) during the second phase of the energy supplying;
$V_{2,Ph1}$ represents the voltage measured by a second photodetector (12) during the first phase of the energy supplying; and
$V_{2,Ph2}$ represents the voltage measured by the second photodetector (12) during the second phase of the energy supplying.

5. Method according to one of claims 3 and 4, wherein the source of dichroism (8) is a source of magnetic field.

6. Method according to claim 5, wherein the source of magnetic field comprises one or several magnets arranged around the cell.

7. Method according to claim 5, wherein the source of magnetic field comprises a coil arranged around the cell, said coil being passed through by a constant current.

8. Method according to claim 5, wherein the source of magnetic field is a fictive magnetic field induced by an AC-Stark shift.

9. Method according to one of claims 7 and 8, wherein the energy supplying is modulated to carry out a third phase in sequence with the first and second phases, the intensity of the energy supplying in the third phase being identical to the intensity of the energy suppling in the first phase and the source of magnetic field being interrupted during the third phase.

10. Method according to one of claims 1 to 9, wherein the cell (3) contains helium, the atomic transition corresponds to the line $D_0$ and the energy supplying in the first phase has an intensity such that the atoms of helium are brought to the metastable state $2^3S_1$.

11. Method according to one of claims 1 to 10, wherein the source of energy (4) is a source of HF discharge.

12. Method according to one of claims 1 to 10, wherein the source of energy (4) is a source of thermal energy.

13. Method according to one of claims 1 to 12, wherein the frequency of the alternating between the first and the second phase is at most 1 kHz.

14. Optical measuring system, comprising:

- a cell (3) filled with an atomic vapour and arranged to receive a laser beam emitted by a laser;
- a source of energy (4) for carrying out a supply of energy to the atoms of the atomic vapour;
- a polarimetric optical assembly (7-13) configured for generating a DAVLL signal ($S_{DAVLL}$) using the laser beam that has passed through the cell; and
- a circuit (14) for controlling the wavelength of the laser on an atomic transition using the DAVLL signal;

characterized int that the source of energy (4) is configured to carry out the alternating of a first phase and of a second phase, the intensity of the energy supply being null or non-null in the second phase and less than the intensity of the energy supplying in the first phase.

FIG. 1

EP 3 454 139 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6099111 A

**Littérature non-brevet citée dans la description**

- Laser frequency stabilization using Zeeman effect. **B. CHÉRON ; H. GILLES ; J. HAMEL ; O. MOREAU ; H. SOREL.** Journal de Physique III. EDP Sciences, 1994, vol. 4, 401-406

- **J. M. REEVES ; O. GARCIA ; C. A. SACKETT.** Temperature stability of a dichroic atomic vapor laser lock. *Appl. Opt., AO,* 2006, vol. 45 (2), 372-376